# EUROPEAN PATENT APPLICATION

(11) **EP 1 635 386 A1**
(43) Date of publication of application: **15.03.2006**
(21) Application number: 04104349.8
(22) Date of filing: 09.09.2004
(51) Int. Cl.: H01L 21/48, B24C 1/00, B24C 3/26

(54) **Method of removing molding residues from lead-frames**

(71) Applicant: STMicroelectronics S.r.l., 20041 Agrate Brianza (Milano) (IT)
(72) Inventor: Crema, Paolo, 20059 Vimercate (MI) (IT)
(74) Representative: Maccalli, Marco

(57) **Abstract**

A method of removing molding residues (**310**) from surfaces (**125,140**) of a lead-frame (**100**) for electronic devices (**108**), exposed from at least one insulating body (**145**) formed by said molding, is provided. The method includes generating a flow (**260**) of accelerated pellets of a frozen substance (**305**), and hitting at least the exposed surfaces (**125,140**) of the lead-frame with the generated flow.

## Description

The present invention relates to package manufacturing processes for electronic devices. Particularly, the present invention relates to a process for removing manufacturing molding residues from lead-frames for electronic device packages.

An electronic device generally includes a circuit that is integrated on a chip of semiconductor material, requiring for its utilization to be housed in a package. The package consists of an insulating body, molded over the chip for protecting it, and, typically, of multiple leads projecting from the insulating body to connect the chip to external circuitries, the leads being in turn connected to the chip by means of tiny wires, e.g. of gold. The package further includes a paddle onto which the chip is mounted, for holding the chip during subsequent manufacturing stages. The packaged electronic devices in most of applications are mounted onto a Printed Circuit Board (shortly, PCB) and the leads are soldered to conductive strips of the PCB to be electrically connected thereto. In packages for power applications, the paddle has a surface that is exposed with respect to the insulating body (such as the so-called exposed-pad packages). In this case, the paddle acts as a heat dissipator, which is soldered in contact with the PCB.

These packages for electronic devices are fabricated from a lead-frame, which is typically produced by dieing or etching a thin metal plate. The lead-frame consists of a support frame structure, from which the leads project, being connected to a plurality of die paddles by means of interconnection bars (that support the die paddles during the package manufacturing process).

Recently, the problem of environmental pollution by lead (Pb) has become very felt and many regulations has been enacted to prevent the use of lead in the manufacture of new electronic devices. Accordingly, many solutions have been adopted to avoid the use of standard SnPb solders and to improve solderability and wire bondability of Pb-free lead-frames. Particularly, in many applications lead-frames (typically of copper, Cu) are treated before the chip assembly by plating the whole surface thereof with additional metal layers (pre-plated lead-frames) for obtaining the required properties.

For example, copper lead-frames treated with exterior coating of less oxidizable metals compatible with existing technology, such as nickel (Ni), palladium (Pd) and gold (Au), have been developed (Ni/Pd/Au pre-plated lead-frames). Palladium plating film has good gold wire bondability and solderability, so it is suitable for IC lead-frames. The Pd-plated lead-frame needs a nickel plating underlayer to maintain high joint strength of soldering parts; for example, the nickel layer is of the order of one micrometer and approximately 0.1 µm of palladium is plated thereon. In addition, the Pd-plated lead-frame is expected to be more likely stable against heat when further plated with an ultra-thin layer (tens of angstroms) of gold on Pd-film surface.

However, it has to be considered that the insulating body, wherein the electronic device is embedded, is produced by a molding process of a plastic material, which can cause flashes and bleeds over the metal surface of the leads and of the exposed paddle (when exposed from the insulating body). Such molding residues on the lead-frame can impair the planarity of the surface of the electronic device that has to be soldered, for example, to the PCB; furthermore, the solderability of the leads and of the die paddle of the electronic device can be greatly reduced. In addition, according to these problems, the heat dissipation capability of the die paddle and the electrical properties of the leads are impaired.

Solutions known in the art for removing the molding residues from the lead-frames propose different types of processes, such as mechanical or chemical/electro-chemical process, or also processes exploiting lasers. Particularly, known mechanical processes consist of a blasting in which solid particles, such as particles of sand, of brass, or other powders, are accelerated to hit the surface of the lead-frames. By means of the mechanical effect of the collision of these solid particles against the lead-frame, the relatively thin layer of molding residues is removed from the metal surface of the lead-frames; similarly, for the same purpose and by means of a similar mechanical effect, also water jets can be exploited.

Mechanical and laser processes can be very aggressive on the metal surface of the lead-frames and can damage the superficial metal layers, especially the ultra-thin layer of the pre-plated lead-frames (such as the Ni/Pd/Au pre-plated lead-frames), then impairing the solderability properties. In addition, wet processes, e.g. exploiting water jets, or chemical/electro-chemical processes, exploiting some kind of chemical agent, cannot be used in assembly automated lines working in clean rooms. It has to be pointed out that, typically, wet processes leave traces of the exploited agent on the packages and, furthermore, produce waste possibly causing environmental damages (such as a toxic chemical agent exploited in a chemical process).

In view of the state of the art outlined in the foregoing, one of the problems that the Applicant has faced has been how to provide a process for removing molding residues from the lead-frames without damaging the metal surface thereof, particularly, a process compatible with assembly automated line working and environmentally friendly.

According to a first aspect of the present invention, a method of removing molding residues is provided as set forth in the appended claim 1.

According to a second aspect of the present invention, a method of packaging electronic devices, as set forth in the appended claim 8, is also encompassed.

Moreover, according to a third aspect of the present invention, an apparatus, as set forth in the appended claim 9, is further provided.

The features and the advantages of the present invention will be made apparent by the following detailed description of a preferred embodiment thereof, provided merely by way of non-limitative example, description that will be conducted making reference to the attached drawings, in which:
**Fig. 1** shows partial bottom plan and sectional side elevated views of a lead-frame, onto which a chip is mounted, after a molding process of a plastic material;
**Fig. 2A** illustrates schematically a portion of an assembly automated line for a package manufacturing process for electronic devices, in which a deflashing process according to an embodiment of the present invention is applied;
**Fig. 2B** shows, still schematically but in a greater detail, a portion of the assembly automated line, in which a flow of dry ice pellets is generated to be exploited in the deflashing process; and
**Fig. 3** is a partial sectional side elevated view of the lead-frame having flashes on its exposed surface, during the deflashing process according to an embodiment of the present invention.

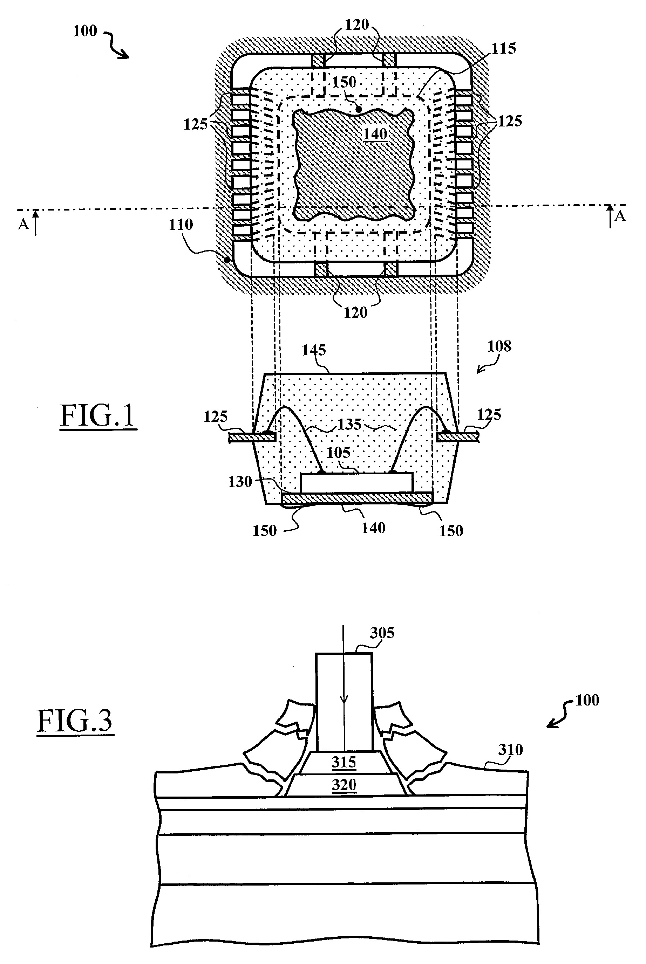

With reference to the drawings, **Fig. 1** illustrates partial bottom plan and sectional elevated side views of a lead-frame **100,** onto which electronic circuits integrated in chips **105** of semiconductor material are mounted. Particularly, the lead-frame **100** is exploited for obtaining leaded packages for electronic devices **108,** e.g. to be mounted onto a PCB.

The lead-frame **100** is produced from a conductive plate, typically, a metal plate, such as a copper plate, having a thickness, for example, of the order of few millimeters. The lead-frame **100** mainly includes a support frame structure **110** and die mounting paddles **115** (only one shown in the drawing) formed in the metal plate. The paddle **115,** having roughly a square shape, primarily serves to mechanically hold one or more chips **105** on its upper surface **130** during a package manufacturing process, the paddle **115** in turn being connected to the support frame **110** by means of a plurality of interconnection bars **120.** The lead-frame **100** further includes a plurality of leads **125** for each paddle **115;** the leads **125** project from respective portions of the support frame **110** facing, for example, two opposite sides of the paddle **115.**

The lead-frame **100** is plated with additional metal layers in order to improve the solderability and the wire bondability. For example, the lead-frame **100** is firstly plated with nickel, obtaining a layer with thickness of, e.g., hundreds of nanometers. A layer of a precious metal, such as palladium, of about tens of nanometers covers the nickel layer. Finally, the lead-frame **100** is plated with a further precious metal, such as gold; typically, the gold layer is very thin, e.g. in the range of 30 - 150 angstroms.

The packaged electronic device **108** includes the chip **105,** mounted onto the upper surface **130** of the paddle **115,** the chip **105** being electrically connected to proximal ends of the corresponding leads **125** by means of tiny metal wires **135** (typically, made of gold). The leads **125** are in turn connectable to external circuitries.

Typically, a plane of the paddles **115** is spaced apart from a plane of the leads **125.** Such a downsetting of the paddle **115** with respect to the leads **125** allows achieving a better looping of the wires **135.** A deep downsetting of the paddle **115** allows maintaining its lower surface **140** (opposite the upper surface **130** onto which the chip **105** is mounted) exposed from an insulating body **145** of the packaged electronic device **108.**

The insulating body **145** (made of a plastic material, such as an epoxy resin) protects the chip **105** and the wires **135.** The insulating body **145** also embeds (in addition to the chip **105** and the wires **135)** an internal portion of the leads **125** (whereto the wires **135** are connected) and a portion of the interconnection bars **120** extending from the paddle **115.** Conversely, an active portion of the leads **125** extending from the support frame **110** of the lead-frame **100** is maintained outside the insulating body **145.**

Typically, the packaged electronic device **108** is mounted onto a PCB, which consists of an insulating substrate on which conductive strips are patterned. For this purpose, the exposed surface **140** of the paddle **115** is soldered onto the PCB and the leads **125** is mechanically and electrically connected to the desired conductive strips of the PCB. The paddle **115** in contact with the PCB improves the heat dissipation during the electronic device **108** operation by forming a heat flow path between the chip **105** and the PCB (the paddle **115** acts as a heat dissipator). Additionally, the paddle **115** can be connected to ground, thus reducing loop inductance for high-frequency applications; in such applications the paddle **115** is called "exposed pad".

The lead-frame **100** is produced by dieing (or also by etching) the metal plate, so as to define the support frame **110,** the paddles **115,** the interconnection bars **120** and the leads **125.** Before assembling chips **105** on its surface, the lead-frame **100** is pre-plated with additional metal layers, as described above, so as to obtain, for example, three additional relatively thin layers of nickel, palladium and gold.

During a package manufacturing process in an assembly automated line, one or more chips **105** are mounted onto each paddle **115** of the lead-frame **100** and fixed thereto by means of a binding material (such as an adhesive compound). The chip **105** is then connected to the corresponding leads **125** through the gold wires **135.**

The complex of the chip **105** and of the wires **135** is embedded into the insulating body **145,** made of an epoxy resin, by means of a molding process, the lower surface **140** of the paddle **115** as well as the active portion of the leads **125** being kept exposed. In the moulding process high temperature and pressure liquefies the epoxy resin, which is then forced through a mould chase into a cavity over the chips **105** mounted onto the lead-frame **100.** The epoxy resin, once hardened, forms the body of the final package.

The packaged electronic devices thus obtained are then separated from each other and from the support frame **110** of the lead-frame **100** by cropping the portions of the interconnection bars **120** projecting from the insulating body **145** and the end portions of the leads **125** connected to the support frame **110.**

During the molding process, residues **150** of epoxy resin, such as flashes or bleeds, inevitably form on the exposed surface **140** of the paddle **115** and on the active portion of the leads **125.** The molding residues **150** cause a reduction of the heat dissipation capability of the paddle **115,** as well as a reduction of the solderability, because of an impaired planarity and a decreased area adapted to be placed directly in contact with, e.g., the PCB. In addition, the molding residues **150** impair the electrical properties of the leads **125** and of the paddle **115,** when exploited as an exposed pad.

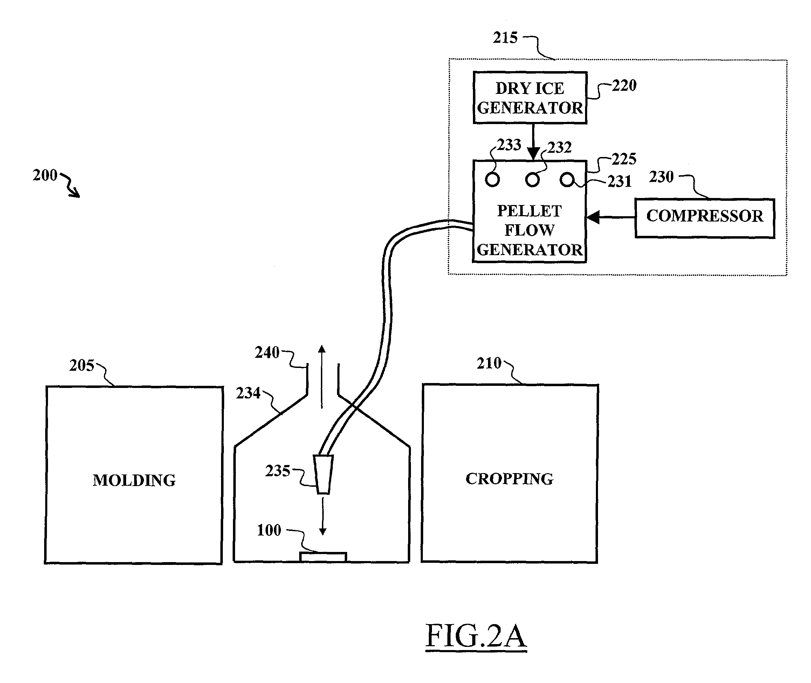

Considering **Fig. 2A,** a portion of the assembly automated line **200** for the package manufacturing process is schematically illustrated, in which a deflashing process according to an embodiment of the present invention is applied.

After the molding process and before cropping the lead-frame **100** for separating the packaged electronic devices from each other, performed in respective portions **205** and **210** of the automated line **200,** a deflashing process is performed for removing the molding residues (i.e., residues of the molding process) from the lead-frame **100.** Particularly, the deflashing process according to an embodiment of the present invention includes a blasting in which suitable pellets are projected against the lead-frame surface to be cleaned.

In detail, in the exemplary embodiment considered, the automated line **200** includes a cryogenic apparatus **215** adapted to produce pellets of a frozen substance, preferably but not limitatively dry ice (e.g., solid carbon dioxide, CO₂) pellets and to project such pellets against the lead-frame. Dry ice is frozen carbon dioxide obtained by solidification at temperature of about - 78.5°C; solid carbon dioxide is called "dry ice" since, in normal atmospheric conditions, it changes directly from a solid phase to a gaseous phase (i.e., it sublimates) without passing through a liquid phase.

The cryogenic apparatus **215** includes a dry ice generator **220,** in which dry ice is produced, for example in the form of roughly cylindrical dry ice elements having diameter of the order of few millimeters (for example, of about 2 mm).

The dry ice cylindrical elements are provided by the dry ice generator **220** to a pellet flow generator **225** (such as the Cryos Cryojet BG 01 model) receiving also dried compressed air from a compressor **230.** The pellet flow generator **225** is adapted to regulate the injection pressure of the compressed air (for example, between 2 and 15 bar), and for this purpose the pellet flow generator **225** is provided with a suitable regulation knob **231.**

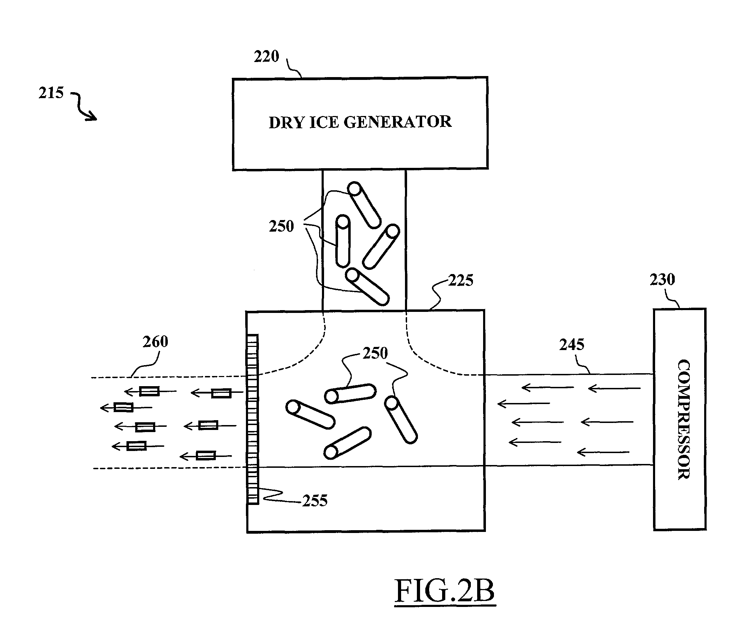

As shown in **Fig. 2B,** the pellet flow generator **225** exploits the propelling force of the compressed air **245** for projecting the received cylindrical dry ice elements **250** against an internal grid **255,** acting as a sieve, with, e.g., square passages having size in a range from approximately 0.5 mm to 2 mm, and preferably in a range from approximately 0.6 mm to 1.4 mm. In this way, the pellet flow generator **225** generates a flow **260** of dry ice pellets having a size depending of the size of the grid passages (e.g., approximately of 0.8 mm), accelerated by the compressed air **245.** The size of the dry ice pellets is limited not to have an excessive mass, and thus an excessive momentum when accelerated, in such a way not to cause bendings of the leads.

Referring back to **Fig. 2A,** the pellet flow generator **225** is preferably provided with two further regulation knobs **232** and **233** for regulating a carrying pressure of the compressed air (for example, between approximately 3 and 7 bar) and a pellet carrying capacity (for example, between approximately 20-150 kg/h) of the pellet flow, respectively.

The lead-frame **100** is exposed, preferably in a clean room **234,** to the dry ice pellet flow provided from the pellet flow generator **225,** for example by means of a nozzle **235** (e.g., a nozzle of a gun). The dry ice pellet flow is directed against the lead-frame surface to be cleaned with regulated pressure and pellet carrying capacity.

The automated line **200** is provided with an exhaust system **240** for eliminating waste produced by the deflashing process, the waste consisting of molding residues removed from the lead-frame surface and of a harmless carbon dioxide gas, produced by sublimation of the dry ice.

With reference to **Fig. 3,** the action of the dry ice pellet flow against the surface of the lead-frame **100** to be cleaned is schematically illustrated.

First, a dry ice pellet **305,** propelled out of the nozzle at a relatively high speed, impacts the surface of the molding residue layer **310.** The flow of dry ice pellets is preferably, but not limitatively, oriented approximately orthogonal to the surface of the lead-frame to be cleaned.

Typically, the molding residue layer **310** has thickness of about some tens of micrometers (such as 10 to 40 µm) and the transfer of the momentum of the pellet **305** to the molding residue layer **310** permits the pellets to penetrate the surface thereof, without however damaging the insulating body, which has a much greater thickness.

The metal area exposed from the insulating body of the package does not endure abrasion, the dry ice having hardness of approximately 1 in the Mohs scale (i.e., close to the talc hardness) and substantially immediately passing, upon impacting the surface of the insulating body, to a powdered form **315.**

The lead-frame is preferably heated over the room temperature, for example, at a temperature of about 80°C, and a thermal shock between the surface of the molding residue layer **310** and the lead-frame **100** follows the impact of the pellet **305,** the pellet being at a low temperature of about -78°C. Cracking of the molding residues subsequent to the thermal shock then favors elimination thereof.

In addition, the dry ice pellet **305** "explodes" on impact, passing from the powdered form **315** to a gaseous form **320** thanks to the sudden substantial increase of temperature. In fact, as the pellet **305** warms when it comes in contact with a surface (the surface of the molding residue layer **310)** that is at a temperature much higher than that of the pellets, it sublimates, directly converting to a harmless gas, which expands rapidly underneath the surface of the molding residue layer **310.** The pressure of the carbon dioxide gas and of the compressed air carrying the pellet flow forces off the cracked molding residue layer **310** from the lead-frame **100** without leaving traces of carbon dioxide on the surface thereof.

The surface of the lead-frame to be cleaned is exposed to the pellet flow for a relatively short period, for example of few seconds (such as 2-3 seconds).

The deflashing process according to the described embodiment of the present invention does not damage the thin superficial metal layer plating the lead-frame and, accordingly, does not impair the solderability and the heat dissipation capability thereof. The devised deflashing process is mainly based on a thermal effect acting on the plastic material layer having a relatively thin thickness. This thermal effect arises from the high temperature difference between the lead-frame surface and the "frozen" pellets, and it cracks the thin plastic material layer. Furthermore, the sublimated pellet applies a pressure inside the cracks in the plastic residue layer, which permits to take it off without abrasion of the metal surface.

A mechanical effect of the deflashing process is limited to a relatively "soft" impact of the dry ice pellets onto the lead-frame surface and to the pressure due to the expansion of the carbon dioxide in the gaseous phase.

In addition, the process according to the described embodiment of the present invention is not a wet processes, and it can be applied in an assembly automated line working in a clean room.

Furthermore, a gas, such as carbon dioxide, is absolutely harmless and not pollutant, and it can be easily eliminated from the assembly automated line without causing environmental damages.

Alternatively, the "frozen" pellets may be made of a different material or composition of materials, which, similarly to carbon dioxide, sublimates or passes sufficiently rapidly from a solid ("frozen") phase to a gaseous phase when undergoing an appropriate change in temperature and/or pressure, e.g., a relatively high temperature difference in pressure conditions close to the atmospheric one. A valid alternative to the carbon dioxide can be, for example, hyponitrous oxide (or nitrogen protoxide, N₂O).

Although the present invention has been disclosed and described by way of an embodiment, it is apparent to those skilled in the art that several modifications to the described embodiment, as well as other embodiments of the present invention are possible without departing from the scope thereof as defined in the appended claims.

For example, the lead-frame can be made of a different material and can be plated with different materials not exhibiting an excessive adhesion to the molding compound (such as copper). The lead-frame can have a different structure and the leads can be arranged facing only one side of the die or all the sides of the die. The relatively small pellets can be produced in a different way, particularly by means of a device different than a grid.

## Claims

1. A method of removing molding residues (**310**) from surfaces (**125**,**140**) of a lead-frame (**100**) for electronic devices (**108**) exposed from at least one insulating body (**145**) formed by said molding,
**characterized in that** the method includes generating a flow (**260**) of accelerated pellets of a frozen substance (**305**), and hitting at least the exposed surfaces (**125**,**140**) of the lead-frame with the generated flow.

2. The method of removing molding residues according to claim 1, wherein generating the flow of accelerated frozen pellets further includes sizing a diameter of the frozen pellets substantially in a range from 0.5 mm to 2 mm, preferably 0.6 to 1.4 mm.

3. The method of removing molding residues according to claim 1 or 2, wherein generating the flow of accelerated frozen pellets includes propelling the frozen pellets by dried compressed air (**245**).

4. The method of removing molding residues according to claim 3, wherein propelling the frozen pellets includes regulating a pressure of the dried compressed air in a range from 2 bar to 7 bar.

5. The method according to any one of the preceding claims, wherein generating a flow of accelerated frozen pellets includes regulating a carrying capability thereof in a range from 20 to 150 kg/h.

6. The method according to any one of the preceding claims, wherein the frozen pellets are made of solid carbon dioxide.

7. The method according to any one of the preceding claims, wherein hitting the exposed surfaces of the lead-frame includes causing the frozen pellets to sublimate.

8. A method of packaging electronic devices (**108**), including:
providing a lead-frame (**100**) for electronic devices, comprising a support plate (**115**) and a plurality of leads (**125**) for each electronic device;
mounting at least one chip (**105**) onto a first surface (**130**) of the support plate,
molding a plastic material for embedding the at least one chip, the leads except an active portion thereof and the support plate except a second surface (**140**) thereof opposite the first surface,
**characterized in that**
the method further includes removing molding residues from the second surface of the support element and from the active portion of the leads by means of a method in accordance with any claim from 1 to 5.

9. An apparatus (**215**) for generating a flow (**260**) of frozen pellets (**305**) adapted to be used in a method according to any claim from 1 to 7, including:
a generator (**220**) of frozen material blocks (**250**);
a sizer unit (**255**) for obtaining frozen pellets with size in a prescribed range from the frozen material blocks; and
a propeller (**230**,**245**) for accelerating the frozen pellets so as to generate a flow of frozen pellets.

10. The apparatus according to claim 9, wherein the sizer unit includes a sieve (**255**), and wherein the propeller accelerates the frozen material blocks against the sieve.
